# EUROPEAN PATENT APPLICATION

(11) **EP 3 671 343 A1**
(43) Date of publication of application: **24.06.2020**
(21) Application number: 19215186.8
(22) Date of filing: 11.12.2019
(51) Int. Cl.: G03F 1/62

(54) **PELLICLE FILM FOR PHOTOLITHOGRAPHY AND PELLICLE PROVIDED WITH THE SAME**

(30) Priority: 17.12.2018 JP 2018235239
(71) Applicant: Shin-Etsu Chemical Co., Ltd., Tokyo (JP)
(72) Inventor: YANASE, Yu, Annaka-shi, Gunma (JP)
(74) Representative: Ter Meer Steinmeister & Partner

(57) **Abstract**

A pellicle film for photolithography, characterized by including a main layer, and graphene provided on one or both sides of the main layer, in which the pellicle film is stretched on one end face of a pellicle frame; and a pellicle for photolithography, including a pellicle film, and a pellicle frame, in which the pellicle film is arranged on an upper end face of the pellicle frame with an adhesive agent or a pressure-sensitive adhesive agent interposed therebetween, and characterized in that the pellicle film has a main layer, and graphene provided on one or both sides of the main layer.

## Description

### CROSS-REFERENCE TO RELATED APPLICATION

This non-provisional application claims priority under 35 U.S.C. §119(a) on Patent Application No. 2018-235239 filed in Japan on December 17, 2018, the entire contents of which are hereby incorporated by reference.

### TECHNICAL FIELD

The present invention relates to a pellicle used as a dust guard when a semiconductor device, an integrated circuit (IC) package, a printed board, a liquid crystal display, an organic electroluminescence (EL) display, or the like is produced.

### BACKGROUND ART

In recent years, in design rules of a large scale integrated circuit (LSI), miniaturization to sub-quarter micron has been promoted, and along with the miniaturization, the wavelength of an exposure light source has been shortened. That is, the exposing light source has shifted from a g-line (436 nm) or i-line (365 nm) by a mercury lamp to a KrF excimer laser (248 nm), an ArF excimer laser (193 nm) or the like, and further, extreme ultra violet (EUV) exposure using an EUV light having a main wavelength of 13.5 nm has been studied.

In the semiconductor production of a LSI, a very large scale integrated circuit (VLSI) or the like, or in the production of a liquid crystal display board, a pattern is formed by irradiating a semiconductor wafer or an original plate for liquid crystal with light, however, if dust adheres to a mask for lithography (simply also referred to as "mask") and a reticle (hereinafter, collectively referred to as "exposure original plate"), which are to be used in this case, this dust absorbs the light or bends the light, so that there has been a problem that the transferred pattern is deformed, the edge becomes coarse, further the base becomes black and dirty, and the dimension, the quality, the appearance, or the like is impaired.

These works are usually performed in a clean room, however, it is still difficult to keep an exposure original plate clean at all times. Accordingly, a method in which exposure is performed after attaching a pellicle as a dust guard onto a surface of an exposure original plate is generally adopted. In this case, foreign matters do not adhere directly onto the surface of the exposure original plate but adhere onto the pellicle, and therefore, if the focal point is set on a pattern of the exposure original plate during lithography, the foreign matters on the pellicle become irrelevant to the transfer.

As to the basic constitution of the pellicle, a pellicle film having a high transmittance for the light to be used for exposure is stretched on an upper end face of a pellicle frame, and further an airtight gasket is formed on a lower end face of the pellicle frame. In general, a pressure-sensitive adhesive agent layer is used for the airtight gasket. The pellicle film is made of nitrocellulose, cellulose acetate, a fluorine-based polymer or the like, which well transmits the light (a g-line (436 nm) or i-line (365 nm) by a mercury lamp, a KrF excimer laser (248 nm), an ArF excimer laser (193 nm) or the like) to be used for exposure, however, for EUV exposure, as the pellicle film, an ultrathin silicon film or a carbon film has been studied.

However, an ultrathin silicon film is extremely fragile, and has a disadvantage that there is a high possibility of being broken during the production or use. In Patent Document 1, a pellicle that has sufficient strength by arranging a porous support frame in a single crystal silicon film is provided, however, it has been found that in this technique, the support frame makes a shadow during lithography, and an adverse effect is exerted.

### Citation List

Patent Document 1: JP-A 2010-256434

### SUMMARY OF THE INVENTION

The present invention has been made in view of such circumstances, and an object of the present invention is to provide a pellicle film having sufficient strength without needing to arrange a support frame, and a pellicle provided with the pellicle film.

The present inventors have found that with regard to the pellicle film to be stretched on one end face of a pellicle frame, a pellicle film is constituted so as to have a single crystal silicon or the like to be used for a silicon on insulator (SOI) layer of a silicon on insulator (SOI) substrate as the main layer, and to have graphene provided on one side or both sides of the main layer, and when the pellicle film is provided on a pellicle, the pellicle film can maintain the high EUV transmittance, and has sufficient mechanical strength without damage of the pellicle film during the preparation of the pellicle, and thus have completed the present invention.

Therefore, the present invention is to provide the following pellicle.
1. A pellicle film for photolithography, being stretched on one end face of a pellicle frame, including a main layer, and graphene provided on one or both sides of the main layer.
2. The pellicle film for photolithography described in the above 1, wherein the main layer is a single crystal silicon.
3. A pellicle for photolithography, including a pellicle film, and a pellicle frame, the pellicle film being arranged on an upper end face of the pellicle frame with an adhesive agent or a pressure-sensitive adhesive agent interposed therebetween, and having a main layer, and graphene provided on one or both sides of the main layer.

### ADVANTAGEOUS EFFECTS OF THE INVENTION

According to the pellicle film of the present invention, the pellicle film can increase the EUV transmittance, and has sufficient strength even without needing to arrange a support frame.

### BRIEF DESCRIPTION OF THE DRAWINGS

FIGS. 1A to 1E are explanatory views for describing an example when producing the pellicle film according to the present invention;
FIGS. 2A to 2E are explanatory views for describing another example when producing the pellicle film according to the present invention; and
FIGS. 3A and 3B are schematic views showing an embodiment of the pellicle provided with the pellicle film according to the present invention, FIG. 3A is a view as viewed from the lower end face side, and FIG. 3B is a view as viewed from the outer face side of the short side.

### DESCRIPTION OF THE PREFERRED EMBODIMENT

Hereinafter, the present invention is described in more detail.

The pellicle film according to the present invention has a main layer, and graphene provided on one or both sides of the main layer.

The graphene is generally made of a single layer of carbon atoms in a honeycomb crystal lattice. This honeycomb structure gives mechanical strength to the graphene. Further, the graphene has high EUV transparency because it is as thin as a single layer of atoms.

As the material for a main layer of the pellicle film, it is not particularly limited, and a material having high transparency to the light in the EUV wavelength band is preferably used. In particular, from the viewpoint that the high transmittance can be expected, a single crystal silicon having the smallest absorption coefficient is suitably adopted.

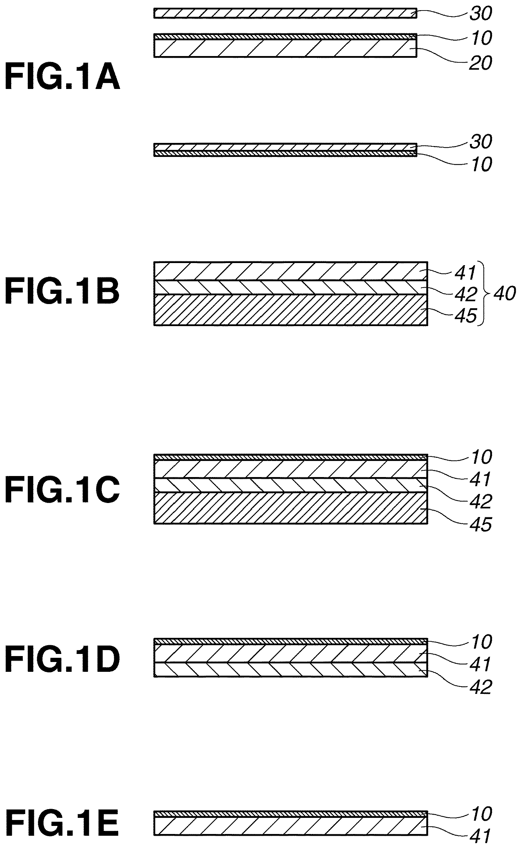

In a case where a single crystal silicon layer is used as the main layer of the pellicle film, a SOI substrate to be provided as a SOI layer can be used. That is, the SOI substrate has a structure in which an insulator of a SiO₂ layer is inserted between a Si substrate and a surface Si layer (SOI layer). As the SOI substrate, for example, a SOI substrate prepared by bonding single crystal silicon wafers to each other with an oxide film of SiO₂ interposed therebetween can be used, crystals of the single crystal silicon wafers have been grown by the Czochralski (CZ) method. For example, FIG. 1B is a schematic sectional view of a SOI substrate 40 having a Si substrate 45, a SOI layer 41, and an insulator layer (BOX layer) 42.

Graphene 10 is transferred onto a surface of the SOI layer 41 of the SOI substrate 40. Graphene can be formed on a substrate such as a Ni foil, or a Cu foil by a chemical vapor deposition (CVD) method, and for example, FIG. 1A shows a laminated structure of graphene 10 formed on a substrate 20 such as a Ni foil, or a Cu foil. In general, multi-layer graphene can be formed on a Ni foil, and single-layer graphene can be formed on a Cu foil. Further, a thermal release sheet 30 may also be attached to the graphene 10. In this case, the substrate 20 is removed by etching, graphene 10 with the thermal release sheet 30 is attached onto a surface of a SOI layer 41 of a SOI substrate 40, and then by removing the thermal release sheet 30, the graphene 10 can be transferred onto the SOI layer 41.

Further, although not particularly shown, graphene formed on a surface of a Ni foil or a Cu foil is coated with an acrylic resin (hereinafter, also referred to as "polymethyl methacrylate (PMMA) resin"), and then the substrate of the Ni foil or the Cu foil is removed by etching, and a graphene-containing acrylic resin layer is attached onto a SOI substrate, thereafter, by dissolving the acrylic resin layer, the graphene can be transferred onto a SOI layer of the SOI substrate.

The layer structure of the graphene to be used in the invention may be a single layer, or may be stacked in multiple layers in a range that does not affect the lithography. In a case of the multiple layers, graphene may be formed in multiple layers in advance, and then transferred onto a substrate. The graphene is preferably a single layer so as not to deteriorate the EUV transmittance.

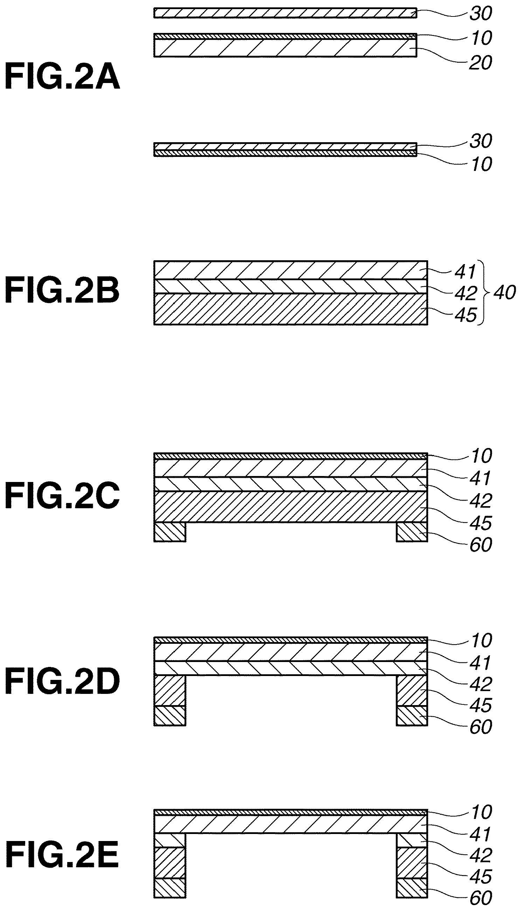

The SOI substrate having a SOI layer to which the graphene obtained as described above is transferred has a cross-sectional structure shown in FIG. 1C. Next, in order to obtain a desired pellicle film, the silicon substrate (Si substrate) in a predetermined region is removed. For example, by adopting a dry etching method using a silicon deep reactive ion etching (DRIE) method or a wet etching method with NaOH, the Si substrate in a predetermined region can be removed, and the state shown in FIG. 1D is obtained. Among these methods, in order not to damage the graphene due to a chemical solution, a dry etching method is preferred. Specifically, as shown in the procedures of FIGS. 2C, 2D and 2E, an etching mask 60 is patterned on a Si substrate 45, and then the Si substrate in a predetermined region having no mask is removed, as a result of which a Si frame (reference sign 45 in FIG. 2E) surrounding the remaining pellicle film may be used only as a support frame for producing a pellicle film, or may be used as a pellicle frame.

Subsequently, by removing the SiO₂ layer of the pellicle film by a treatment with a dilute hydrofluoric acid solution (hereinafter, also referred to as "hydrofluoric acid (HF) treatment"), a pellicle film with graphene can be obtained. By providing graphene by using a thermal release sheet on the side where graphene has not been provided of the pellicle film with graphene, graphene may be provided on both sides of the pellicle film. By providing graphene on both sides, the mechanical strength of the pellicle film is further improved, and a possibility that the pellicle film is broken during the use of the pellicle can be reduced.

An ordinary pellicle is constituted of a pellicle frame, a pellicle film, a pellicle film adhesive layer, a mask substrate or adhesive layer of exposure original plate (hereinafter, referred to as "mask adhesive layer"), vent holes, a filter, and the like. Further, in general, a separator is attached to the pellicle in order to protect a surface of the mask adhesive layer.

In a case where a pellicle frame is attached to a pellicle film, an adhesive agent can be used. Specifically, examples of the adhesive agent include an acrylic resin adhesive agent, an epoxy resin adhesive agent, a silicone resin adhesive agent, and a fluoropolymer such as a fluorine-containing silicone adhesive agent. In particular, from the viewpoint of the heat resistance, a silicone adhesive agent is suitably used. The adhesive agent is diluted with a solvent as needed, and applied onto an upper end face of the pellicle frame. As the coating method in this case, a method by brushing, spraying, automatic dispenser, or the like is adopted.

The mask adhesive layer for attaching a pellicle to a mask substrate can be formed by a known pressure-sensitive adhesive agent such as double-faced adhesive tape, a silicone-based pressure-sensitive adhesive agent, or an acrylic pressure-sensitive adhesive agent. In general, a mask adhesive layer is formed on a lower end face of a pellicle frame, and further a separator is peelably attached.

As the material for a pellicle frame, it is not particularly limited, and a known material can be used. As to a pellicle frame for EUV, the pellicle frame may be exposed to high temperature, and therefore, as the material, a material having low thermal expansion coefficient is preferred. Examples of the material include Si, SiO₂, SiN, quartz, invar, titanium, and a titanium alloy, and in particular, from the viewpoint of the ease of processing or the lightness in weight, titanium, or a titanium alloy is preferably used.

To the pellicle frame, a vent hole or a notch part may be provided in order to cope with the changes in atmospheric pressure inside and outside the pellicle. In that case, in order to prevent foreign matters from passing through the ventilation part, a filter may be provided to the pellicle frame.

A release layer for protecting a pressure-sensitive adhesive agent may be attached onto a lower end face on the mask side of the pressure-sensitive adhesive agent of the pellicle frame. As the material for the release layer (separator), it is not particularly limited, and for example, polyethylene terephthalate (PET), polytetrafluoroethylene (PTFE), tetrafluoroethylene-perfluoroalkyl vinyl ether copolymer (PFA), polyethylene (PE), polycarbonate (PC), polyvinyl chloride (PVC), polypropylene (PP) or the like can be used. Further, depending on the adhesive strength of the mask adhesive layer, a release agent such as a silicone-based release agent, or a fluorine-based release agent may be applied onto a surface of the separator. This separator can be omitted by devising a pellicle storage container, a pellicle support method, or the like.

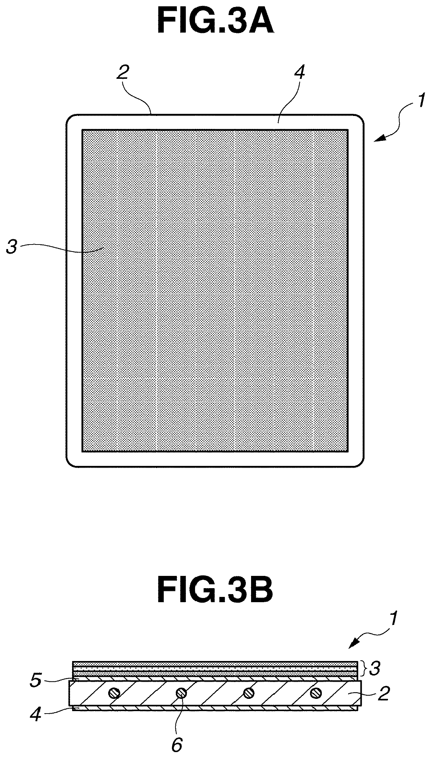

FIGS. 3A and 3B show an example of the pellicle 1 according to the present invention. A pellicle film 3 is bonded and stretched onto an upper end face of a pellicle frame 2 by a pellicle film adhesive layer 5. Further, in detail, in this pellicle film, graphene 10 is formed, and the pellicle film has a cross-sectional structure shown in FIG. 1E. In addition, on a lower end face of the pellicle frame 2, a mask pressure-sensitive adhesive agent 4 to be attached onto a photomask (particularly not shown) is arranged. In this regard, the reference sign 6 denotes a vent hole formed on the lower end side of the frame.

### EXAMPLES

Hereinafter, the present invention is specifically described by referring to Examples and Comparative Examples, however, the present invention is not limited at all by the following Examples.

### Example 1

A SOI substrate in which a SOI layer made of a silicon single crystal having a thickness of 50 nm was attached onto a silicon substrate having a diameter of 200 mm and a thickness of 725 µm with a silicon thermal oxide film having a thickness of 200 nm interposed between the SOI layer and the silicon substrate was used.

A Cu foil on which single layer graphene had been formed by a CVD method was prepared, and a thermal release sheet of which the adhesive strength disappeared at 100°C was bonded on the single layer graphene side. The Cu foil was removed by etching, and then the remaining portion was washed with pure water, as a result of which the single layer graphene arranged on the thermal release sheet was obtained.

The thermal release sheet with single layer graphene was bonded onto the entire surface of the SOI layer on the SOI substrate, and the heat release sheet was removed by heating to 100°C, and the single layer graphene was transferred onto the SOI layer.

Next, the obtained material was cut into a rectangle having an external size of 149 mm × 115 mm by machining. An etching mask was patterned on the outer peripheral part except for a rectangle having a size of 145 mm × 111 mm in the central part on the silicon substrate side, and then the central part of the silicon substrate, which had not been masked, was etched by a dry etching method using a silicon DRIE method.

Next, HF treatment was performed to remove the silicon thermal oxide film layer in the central part, and then by washing the remaining portion sufficiently with pure water, a pellicle film including a silicon single crystal (main layer) and single layer graphene provided on one side of the main layer was prepared. Further, the remaining silicon substrate was used as a pellicle frame. By applying a mask pressure-sensitive adhesive agent onto an end face where no film had been attached of the pellicle frame, a pellicle was completed.

In this pellicle, the damage of the pellicle film was not confirmed.

### Example 2

Single layer graphene was transferred onto the entire surface of a SOI layer on a SOI substrate by using a thermal release sheet in a similar manner as in Example 1.

An etching mask was patterned in a range of 10 mm inside from the outer edge on the silicon substrate side, and then the part of the silicon substrate, which had not been masked, was etched by a dry etching method using a silicon DRIE method.

Next, HF treatment was performed to remove the silicon thermal oxide film layer in the central part, and then by washing the remaining portion sufficiently with pure water, a pellicle film including a silicon single crystal (main layer) and graphene provided on one side of the main layer was prepared.

A pellicle frame, which was made of titanium, had an external size of 149 mm × 115 mm × 2.5 mm and an internal size of 145 mm × 111 mm × 2.5 mm, and was provided with a mask pressure-sensitive adhesive agent on a lower end face of the pellicle frame, was bonded to the pellicle film on the side where graphene had been provided by using a silicone adhesive agent (KE-101A/B manufactured by Shin-Etsu Chemical Co., Ltd.). The excess pellicle film was cut off by machining, and a pellicle was completed. In this pellicle, the damage of the pellicle film was not confirmed.

### Example 3

Single layer graphene was transferred onto the entire surface of a SOI layer on a SOI substrate by using a thermal release sheet in a similar manner as in Example 1.

An etching mask was patterned in a range of 10 mm inside from the outer edge on the silicon substrate side, and then the part of the silicon substrate, which had not been masked, was etched by a dry etching method using a silicon DRIE method.

Next, HF treatment was performed to remove the silicon thermal oxide film layer in the central part, and then by washing the remaining portion sufficiently with pure water, a silicon single crystal film with single layer graphene was prepared.

Further, the thermal release sheet with single layer graphene was bonded to the silicon single crystal film with graphene on the silicon single crystal side, the heat release sheet was removed by heating to 100°C, and the single layer graphene was transferred. As a result, a pellicle film including a silicon single crystal film (main layer), and graphene formed on both of the upper end face and lower end face of the main layer was prepared.

A pellicle frame, which was made of titanium, had an external size of 149 mm × 115 mm × 2.5 mm and an internal size of 145 mm × 111 mm × 2.5 mm, and was provided with a mask pressure-sensitive adhesive agent on a lower end face of the pellicle frame, was bonded to the pellicle film by using a silicone adhesive agent (KE-101A/B manufactured by Shin-Etsu Chemical Co., Ltd.).

The excess pellicle film was cut off by machining, and a pellicle was completed.

In this pellicle, the damage of the pellicle film was not confirmed.

### Example 4

A SOI substrate in which a SOI layer made of a silicon single crystal having a thickness of 50 nm was attached onto a silicon substrate having a diameter of 200 mm and a thickness of 725 µm with a silicon thermal oxide film having a thickness of 100 nm interposed between the SOI layer and the silicon substrate was used.

Single layer graphene formed on a Cu foil by a CVD method was coated with a PMMA resin. After that, the Cu foil was dissolved by etching, and by washing the remaining portion with pure water, single layer graphene provided on the PMMA resin was obtained. The PMMA resin with single layer graphene was bonded to the SOI substrate, and the single layer graphene was arranged on the SOI substrate.

An etching mask was patterned in a range of 10 mm inside from the outer edge on the silicon substrate side, and then the part of the silicon substrate, which had not been masked, was etched by a dry etching method using a silicon DRIE method.

Next, HF treatment was performed to remove the silicon thermal oxide film layer in the central part, and then by dissolving the PMMA layer with acetone, and washing the remaining portion with pure water, a pellicle film including a silicon single crystal (main layer) and single layer graphene formed on one side of the main layer was obtained.

A pellicle frame, which was made of titanium, had an external size of 149 mm × 115 mm × 2.5 mm and an internal size of 145 mm × 111 mm × 2.5 mm, and was provided with a mask pressure-sensitive adhesive agent on a lower end face of the pellicle frame, was bonded to the pellicle film on the side where graphene had been provided by using a silicone adhesive agent (KE-101A/B manufactured by Shin-Etsu Chemical Co., Ltd.).

The excess pellicle film was cut off by machining, and a pellicle was completed.

In this pellicle, the damage of the pellicle film was not confirmed.

### Example 5

A SOI substrate in which single layer graphene was bonded onto a PMMA resin was prepared in a similar manner as in Example 4.

An etching mask was patterned in a range of 10 mm inside from the outer edge on the silicon substrate side, and then the part of the silicon substrate, which had not been masked, was etched by a DRIE method.

Next, HF treatment was performed to remove the silicon thermal oxide film layer in the central part. After washing with pure water, the PMMA resin with single layer graphene was bonded on the single crystal silicon side so that the graphene was attached on the single crystal silicon film side. In the end, by dissolving the PMMA layer with acetone, and washing the remaining portion with pure water, a pellicle film including a silicon single crystal film (main layer), and single layer graphene formed on both of the upper end face and lower end face of the main layer was prepared.

A pellicle frame, which was made of titanium, had an external size of 149 mm × 115 mm × 2.5 mm and an internal size of 145 mm × 111 mm × 2.5 mm, and was provided with a mask pressure-sensitive adhesive agent on a lower end face of the pellicle frame was bonded to the pellicle film by using a silicone adhesive agent (KE-101A/B manufactured by Shin-Etsu Chemical Co., Ltd.).

The excess pellicle film was cut off by machining, and a pellicle was completed.

In this pellicle, the damage of the pellicle film was not confirmed.

### Comparative Example 1

An attempt of preparation of a pellicle film was made in a similar manner as in Example 1 except that the SOI substrate was not provided with graphene. As a result, when an attempt was made to remove the silicon thermal oxide film layer by HF treatment, the film was broken during etching.

Japanese Patent Application No. 2018-235239 is incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A pellicle film for photolithography, being stretched on one end face of a pellicle frame, comprising: a main layer, and graphene provided on one or both sides of the main layer.

2. The pellicle film for photolithography according to claim 1, wherein the main layer is a single crystal silicon.

3. A pellicle for photolithography, comprising: a pellicle film, and a pellicle frame, the pellicle film being arranged on an upper end face of the pellicle frame with an adhesive agent or a pressure-sensitive adhesive agent interposed therebetween, and having a main layer, and graphene provided on one or both sides of the main layer.
